Europäisches Patentamt

(19) European Patent Office

Office européen des brevets

(11) EP 0 786 862 A1

(12) EUROPEAN PATENT APPLICATION

(43) Date of publication:
30.07.1997 Bulletin 1997/31

(51) Int. Cl.6: H03H 11/04

(21) Application number: 96200160.8

(22) Date of filing: 23.01.1996

(84) Designated Contracting States:
BE CH DE ES FR GB IT LI NL PT SE

(71) Applicant: ALCATEL BELL
Naamloze Vennootschap
B-2018 Antwerpen 1 (BE)

(72) Inventors:
• Op de Beeck, Edmond Celina Joyef
  B-2800 Mechelen (BE)
• Haspeslagh, Johan Joseph Gustaaf
  B-3210 Linden (BE)
• Moons, Elve Desiderius Jozef
  B-3560 Lummen (BE)
• Willocx, Eddie Louis Marie
  B-2830 Willebroek (BE)

(54) **Linear time invariant electrical system with variable transfer function parameters and line impedance synthesis circuit including such a system**

(57) A linear time invariant electrical system adapted to convert an electrical input signal to an electrical output signal, according to a transfer function having one variable pole, one variable zero and variable gain, includes a first subsystem (SUB1) adapted to receive said input signal (SIN) and to generate a first subsystem output signal (SOUTSUB1) as said input signal multiplied with a first variable coefficient, a second subsystem (SUB2) adapted to perform a variable low-pass filtering of said input signal (SIN), thereby generating a second subsystem output signal (SOUTSUB2), a third subsystem (SUB3) adapted to multiply said second subsystem output signal (SOUTSUB2) with a second variable coefficient, thereby generating a third subsystem output signal (SOUTSUB3), and a summation circuit (SUM) adapted to add said third subsystem output signal (SOUTSUB3) to said first subsystem output signal (SOUTSUB1) thereby generating said output signal (SOUT). A line impedance synthesis circuit including such a system is described, allowing to accurately control ac line impedance parameters on-chip.

Fig.1

EP 0 786 862 A1

## Description

The present invention relates to a linear time invariant electrical system and a line impedance synthesis circuit including such a linear time invariant electrical system as described by the preamble of claims 1 and 5 respectively.

Such a line impedance synthesis circuit including such a linear time invariant electrical system with variable transfer function parameters, is already known in the art, e.g. from the article 'A Monolithic 70-V Subscriber Line Interface Circuit", written by J.P. Pieters, E. Moons, E. Willocx and S. Beckers, IEEE Journal of Solid-State Circuits, Vol. SC-21, N° 2, April 1986, pp 252-258, wherein, on p 253 and 254, the circuit schematic principle of ac line impedance synthesis is described. This circuit includes a ZCO amplifier as shown on Fig. 4 of the mentioned prior art document. This ZCO amplifier has a resistive and a capacitive input impedance as well as a resistive and capacitive feedback impedance. For an input capacitance having an infinite value the transfer function of this ZCO amplifier reduces to a transfer function having one pole and one zero, the values of which may be adjusted by choosing appropriate values of the described external resistors and capacitor included within the feedback path. By changing these resistor and capacitance values the gain of the transfer function is varied as well. Thus this known electrical embodiment realizes the subject transfer function, the variations of which parameters are realized by means of the use of different printed circuit boards each including a specific combination of resistor and capacitor values. These variations in the parameters lead to different ac synthesized impedance values when using this embodiment in an ac line impedance synthesis circuit.

An object of the present invention is to provide a linear time invariant electrical system and a line impedance synthesis circuit of the same kind as the above known one, but using a different architecture, thereby providing an alternative solution for realizing the desired variable transfer function which directly realizes the desired synthesized ac line impedance.

According to the invention, this object is achieved by the fact that said linear time invariant electrical system as well as the line impedance synthesis circuit of which this linear time invariant electrical system forms part, includes a first subsystem , a second subsystem, a third subsystem and a summation circuit, each of these mentioned subsystems performing a specific function as described in claims 1 and 5.

In this way, a linear time invariant electrical system realizing the desired variable transfer function is obtained, the varying pole being defined by the second subsystem, the varying gain being defined by the first and the third subsystems, whereas the varying zero is defined by the first,second and third subsystem together, as will be explained later in the description.

An additional characteristic feature of the present invention is that, said three subcircuits and said summation circuit are realized according to claims 2, 3 and 4 and that said line impedance synthesis circuit is realized according to claims 6,7 and 8.

In this way, the described electrical implementations of the linear time invariant electrical system and the line impedance synthesis circuit are adapted to perform the functions as described in claims 1 and 5 respectively, but on an electrically continuous time analog input signal. The input signal is amplified or attenuated in the first variable gain amplifier arrangement constituting the first subsystem, and in parallel the input signal undergoes a low-pass filtering function with a variable cut off-frequency being determined by the values of the resistor, of the capacitor and of the variable gain of the second variable gain amplifier arrangement included within the second subsystem, whereas the third subsystem again consists of a third variable gain amplifier arrangement. In this way the variable values of the pole, zero and gain are determined by variable gain values of variable gain amplifier circuits. All mentioned variable gain amplifier circuits as well as the summation circuit consisting of a summing amplifier arrangement can be made part of an integrated circuit. Compared to the prior art method where for each combination of the values of the pole, zero and gain a different printed circuit board had to be provided, the subject method allows for on-chip control of the variable parameters, thereby realizing a serious cost reduction. The same is true for the ac line impedance synthesis circuit including an embodiment of this linear time invariant circuit, in which variations of the realized ac impedance now are realized on chip, realizing a serious cost reduction compared to the prior art solution.

Still another characteristic feature of the present invention is that a line impedance synthesis circuit including an electrical embodiment of the mentioned linear system, is further realized according to claim 9.

In this way the resistor and the capacitor values have a very small tolerance, and are accurate and reproducible since they are a non-integrated precision resistor and capacitor. On the other hand ratio's of on-chip resistors are accurate and reproducible as well, the resulting embodiment allowing for a very precise and reproducible on-hip determination of the pole, the zero and the gain of the transfer function. Since this transfer function is directly related to the synthesized ac line impedance, the thus realized ac impedance is precisely controlled on-chip as well . This is extremely important in applications in subscriber line circuits in which the ac impedance needs to be adjusted very precisely.

Another characteristic feature of the line impedance synthesis circuit is described in claim 10. This feature enables the variation of the above mentioned variable gain values to be made on-chip programmable, thereby adding to the flexibility of the system, which, compared to the prior art method, is a serious advantage.

The above mentioned and other objects and features of the invention will become more apparent and the invention itself will be best understood by referring to the following description of an embodiment taken in conjunction with the accompanying drawings wherein:

Fig. 1 shows a basic scheme of the subject linear time invariant electrical system,
Fig. 2 shows an embodiment of the second subsystem used within the linear time invariant electrical system according to Fig. 1,
Fig. 3 shows a basic scheme of a line impedance synthesis circuit including the linear time invariant electrical system according to Fig. 1.

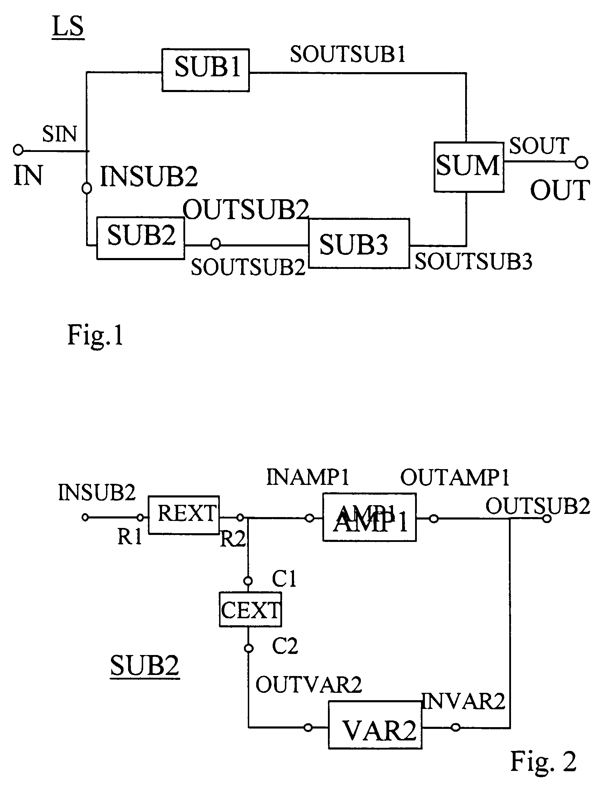

The subject linear time invariant electrical system LS is adapted to convert an electrical input signal SIN applied to an input terminal IN into an electrical output signal SOUT, applied to an output terminal OUT, as is shown in Fig. 1. In general, these signals can either be continuous or discrete, analog or digital. Linear time invariant systems are mathematically described by means of a transfer function. For continuous or analog signals this transfer function is described using s- or Laplace parameters, whereas for time-discrete signals usually z-parameters are used. In the following part the transfer functions will be described using s-parameters. It is however evident for a person skilled in the art how to obtain the equivalent expression as a function of z-parameters. This will therefore not be further described.

Basically the linear time invariant electrical system LS includes three subsystems, SUB1, SUB2 and SUB3, and a summation circuit SUM, as shown in Fig. 1. The first subsystem, SUB1, receives the input signal SIN and converts this input signal SIN into a first subsystem output signal SOUTSUB1 by either amplifying or attenuating SIN with a first variable coefficient, hereafter called G1. Note that G1 can be positive or negative. The transfer function F1 of the first subsystem can thus be described as :

$$F1 = \mathcal{L}(SOUTSUB1)/\mathcal{L}(SIN) = G1 \qquad (1)$$

with $\mathcal{L}$ denoting that the Laplace transform of a signal is considered

The input signal SIN is also applied to the second subsystem SUB2 . The function of this second subsystem is to perform a variable low-pass filtering of this input signal to generate a second subsystem output signal SOUTSUB2. Such a variable low-pass filter can be described by a transfer function F2 having one variable pole :

$$F2 = \mathcal{L}(SOUTSUB2)/\mathcal{L}(SIN) = 1/(1+ s/p) \qquad (2)$$

the variable pole being equal to -p. For stability reasons, the value of the pole has to be negative and different from zero. This implies p to be positive and larger than 0.

The output signal of the second subsystem, SOUTSUB2, serves as input signal of the third subsystem SUB3. This third subsystem again either amplifies or attenuates SOUTSUB2 with a second variable coefficient hereafter called G2, to a third subsystem output signal SOUTSUB3. Note that G2 can also be both positive or negative. The transfer function F3 of the third subsystem is thus :

$$F3 = \mathcal{L}(SOUTSUB3)/\mathcal{L}(SOUTSUB2) = G2 \qquad (3)$$

The linear time invariant electrical system LS further includes a summation circuit , SUM, receiving the output signal of the first subsystem, SOUTSUB1 and the output signal of the third subsystem, SOUTSUB3, and adding both signals to generate the output signal, SOUT, of the linear time invariant electrical system.

The global transfer function F of the linear time invariant electrical system can be expressed as

$$F = \mathcal{L}(SOUT) / \mathcal{L}(SIN) = \mathcal{L}((SOUTSUB3+SOUTSUB1)) / \mathcal{L}(SIN)$$

$$= G2.1/(1+s/p) + G1$$

$$= G(1+s/z)/(1+s/p) \qquad (4)$$

with

$G = \quad G1+G2$

$z = \quad p(G1+G2)/G1$

resulting in a transfer function having variable gain, one variable pole and one variable zero. The variable gain is determined by the first variable coefficient G1 of the first subsystem SUB1 and by the second variable coefficient G2 of the third subsystem SUB3. The variable pole is determined by the second subsystem SUB2 and the variable zero is a function of all 3 variable parameters G1, G2 and the variable pole -p.

In an electrical embodiment realizing the described transfer function on continuous time analog electrical signals the first subsystem consists of a variable gain amplifier arrangement, the variable gain of which is denoted by GIAN1 and which is equal to the first variable coefficient G1. Such a variable gain amplifier arrangement is well known to a person skilled in the art and will therefore not further be described.

An embodiment of the second subsystem is shown in Fig. 2. The second subsystem SUB2 has an input terminal INSUB2 to which the input signal SIN is applied and an output terminal OUTSUB2 which supplies the second subsystem output signal SOUTSUB2 . The input terminal is coupled to a first terminal R1 of a resistor REXT. A second terminal R2 of this resistor REXT is coupled to an input terminal INAMP1 of a unity gain non-inverting amplifier circuit AMP1 and to a first terminal C1 of a capacitor CEXT. An output terminal OUTAMP1 of this unity gain non-inverting amplifier circuit AMP1 is further coupled to the second subsystem output terminal OUTSUB2 and to an input terminal INVAR2 of a second variable gain amplifier arrangement VAR2. An output terminal OUTVAR2 of this second variable gain amplifier arrangement VAR2 is coupled to a second terminal C2 of the capacitor CEXT. The gain value of this second variable gain amplifier arrangement is denoted GAIN2 and can have all negative values, but is limited in positive values in this sense that GAIN2 cannot be larger than 1.

Possible embodiments of a unity gain non-inverting amplifier circuit and of a variable gain amplifier arrangement are well known to a person skilled in the art and will therefore not be further described here.

A person skilled in the art can calculate the transfer function of this shown embodiment of the second subsystem to be equal to :

$$F2 = 1/(1+(1-GAIN2)RCs)$$

with R being the resistance value of the resistor REXT and C denoting the capacitance value of the capacitor CEXT. This corresponds to the generic form as given by expression (2) of the transfer function of the second subsystem : F2=1/(1+s/p) in which p is now equal to 1/(1-GAIN2)RC . By varying GAIN2 from minus infinity to 1, p can have all values ranging from zero towards infinity. This embodiment thus realizes a variable low-pass filtering function, the variation being realized by varying the value GAIN2 of the gain of the second variable gain amplifier arrangement, thereby covering all negative values of the pole since the pole of this system is determined as -1/(1-GAIN2)RC .

A possible electrical embodiment of the third subsystem is again a variable gain amplifier arrangement, similar to the one realizing the first subsystem, having a variable gain value denoted by GAIN3 and equal to the second variable coefficient G2. Such an arrangement is well known to a person skilled in the art and will therefore not be further described.

Finally an embodiment of the summation circuit may consist of a summing amplifier. Summing amplifiers are well known to a person skilled in the art, and will therefore not be further described here.

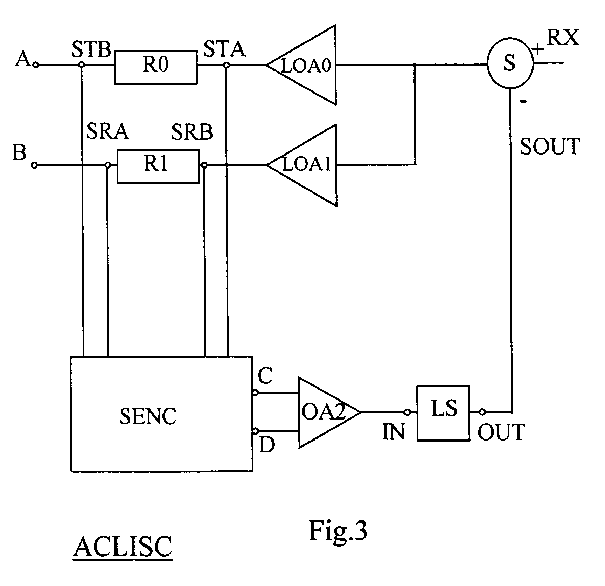

The described linear electrical system is used in an ac line impedance synthesis circuit ACLISC for a telecommunication line circuit. A schematic of this line impedance synthesis circuit ACLISC is shown in Fig. 3. The basic principle of such a circuit is described in the article 'A Monolithic 70-V Subscriber Line Interface Circuit", written by J.P. Pieters, E. Moons, E. Willocx and S. Beckers, IEEE Journal of Solid-State Circuits, Vol. SC-21, N° 2, April 1986, pp 252-258, but it will be repeated here to clarify the invention. This ac line impedance synthesis circuit is coupled to line terminals A,B of a two wire bi-directional telecommunication line and includes two operational line amplifiers LOA0 and LOA1. An output terminal of a first operational line amplifier LOA0 is coupled to a first terminal STA of a first line feed resistance R0, whereas an output terminal of the second operational line amplifier LOA1 is coupled to a first terminal SRB of a second line feed resistance R1. The second terminals STB,SRA of both line feed resistances are coupled to the line terminals A,B of the two-wire bi-directional telecommunications line respectively. All line feed resistance terminals are parallel coupled to a sensing circuit SENC including a Herther bridge also known as sense bridge. This sensing circuit has two output terminals C and D which are coupled to respective inputs of an operational sense amplifier OA2. An output terminal of this sense amplifier is coupled to the input terminal IN of the linear time invariant electrical system LS, an output terminal OUT of which is coupled to input terminals of the two operational line amplifiers LOA0 and LOA1 via a summing circuit S which subtracts the signal SOUT supplied to the output terminal of the linear time invariant electrical system LS from an input signal RX applied to the AC line impedance synthesis circuit ACLISC. Besides the mentioned line amplifiers LOA0 and LOA1 also the line feed resistances R0, R1, the sensing circuit SENC, the sense amplifier OA2 as well as the linear system LS and the summing circuit form part of the ac line impedance synthesis circuit ACLISC. According to the mentioned prior art document on p. 254, the synthesized line impedance $Z_{AC}$ is given by

$Z_{AC}=2R_s(N+1)$, with Rs denoting the resistance value of the line feed resistances R0 and R1 and with N denoting the total gain in the loop. This total loop gain N is determined by the transfer function of the sense amplifier OA2, the transfer function of the operational line drivers LOA0 and LOA1, and the transfer function of the linear system, according to what is described on page 254 of the mentioned prior art document.

In an embodiment of the subject invention the linear system LS is realized according to what was described in a previous paragraph and wherein in particular the variable gain values GAIN1, GAIN2 and GAIN3 of the variable gain amplifier arrangements VAR1, VAR2 and VAR3 respectively are realized by variable ratio's of sets of variable resistors which form part of the respective variable gain amplifier arrangements. Dependent on the value of the complex impedance $Z_{AC}$ to be realized the variable gain values GAIN1, GAIN2 and GAIN3 of the corresponding variable gain amplifier arrangements VAR1, VAR2 and VAR3 respectively, are adapted by controlling these variable ratio's of the corresponding sets of variable resistors. This embodiment is suited for integration on an integrated circuit. However, since the ac impedance has to be realized with tight tolerance on its value, the resistor REXT as well as the capacitor CEXT do not form part of this integrated circuit, since with the state of the art of integrated circuit technologies at the time of the invention, it is not possible to obtain an absolute accuracy of on-chip resistor and capacitor values that can meet the accuracy and tolerance values obtained with discrete precision resistors and precision capacitors. Since both the resistance value R as well as the capacitance value C, appear in the formula for determining the value of the pole of the linear system LS, their values must be as accurate as possible. Therefore the resistor REXT as well as the capacitor CEXT are an external precision resistor and capacitor respectively.

On-chip control of resistance ratio's on the other hand, is realizable in a precise way. Therefore, except for the resistor REXT and the capacitor CEXT the linear system forms part of an integrated circuit. In an embodiment subject of the invention the control of the ratio of the set of variable resistors is made software programmable by means of a non-volatile memory circuit included within each variable gain amplifier arrangement. It is however possible, in another embodiment to realize a software control of these resistor ratio's according to other methods known to a person skilled in the art. These will however not be described here.

In an embodiment subject of the invention each non-volatile memory circuit included within each of the variable gain amplifier arrangements thus contains the programmed variable gain value determining the value of the ratio of the set of variable resistors forming part of the respective variable gain amplifier arrangements. A control circuit being included in each variable gain amplifier arrangement is then adapted to generate from this programmed variable gain value the appropriate variable ratio of the corresponding set of resistors for determining the gain of the corresponding variable gain amplifier arrangement. Since this is also a well-known principle to a person skilled in the art, this non-volatile memory circuit as well as the control circuit determining the variable ratio of resistor values will not be further described here.

An additional high frequency pole determining circuit can be added, if desired, in series between the first subsystem and the summation circuit. Such an additional high frequency pole may be needed for stability reasons as is well known to a person skilled in the art. This will therefore not be further described.

While the principles of the invention have been described above in connection with specific apparatus, it is to be clearly understood that this description is made only by way of example and not as a limitation on the scope of the invention.

## Claims

1. Linear time invariant electrical system (LS) adapted to convert an electrical input signal (SIN) to an electrical output signal (SOUT), according to a transfer function having one variable pole, one variable zero and variable gain, characterized in that said linear time invariant electrical system includes a first subsystem (SUB1) adapted to receive said input signal (SIN) and to generate a first subsystem output signal (SOUTSUB1) as said input signal (SIN) multiplied with a first variable coefficient, a second subsystem (SUB2) adapted to perform a variable low-pass filtering of said input signal (SIN), thereby generating a second subsystem output signal (SOUTSUB2), a third subsystem (SUB3) adapted to multiply said second subsystem output signal (SOUTSUB2) with a second variable coefficient, thereby generating a third subsystem output signal (SOUTSUB3), and a summation circuit (SUM) adapted to add said third subsystem output signal (SOUTSUB3) to said first subsystem output signal (SOUTSUB1) thereby generating said output signal (SOUT).

2. Linear time invariant electrical system according to claim 1 characterized in that said first subsystem (SUB1) is realized by a first variable gain amplifier arrangement with a first variable gain value equal to said first variable coefficient.

3. Linear time invariant electrical system according to claim 1 characterized in that said second subsystem (SUB2) has an input terminal (INSUB2) for receipt of said input signal (SIN) and an output terminal (OUTSUB2) for supplying said second subsystem output signal (SOUTSUB2), in that said second subsystem further includes a unity gain non-inverting amplifier circuit (AMP1) having an input terminal (INAMP1) and an output terminal (OUTAMP1), in that said second subsystem further includes a second variable gain amplifier arrangement (VAR2) with a second variable gain value being smaller than 1, said second variable gain amplifier arrangement (VAR2) having an input terminal (INVAR2) and an output terminal (OUTVAR2), in that said second subsystem (SUB2) further includes a resistor (REXT) and a capacitor (CEXT), said input terminal (INSUB2) of said second subsystem being coupled to a first terminal (R1) of said resistor (REXT), a second terminal (R2) of said resistor (REXT) being coupled to said input terminal (INAMP1) of said unity gain non-inverting amplifier circuit (AMP1) and being coupled to a first terminal (C1) of said capacitor (CEXT), said output terminal (OUTAMP1) of said unity gain non-inverting amplifier circuit (AMP1) being coupled to said output terminal (OUTSUB2) of said second subsystem and being coupled to said input terminal (INVAR2) of said second variable gain amplifier arrangement (VAR2), said output terminal (OUTAMP2) of said second variable gain amplifier arrangement (VAR2) being coupled to a second terminal (C2) of said capacitor (CEXT).

4. Linear time invariant electrical system according to claim 1 characterized in that said third subsystem (SUB3) is realized by a third variable gain amplifier arrangement with a third variable gain value equal to said second variable coefficient, and in that said summation circuit (SUM) is realized by a summing amplifier arrangement.

5. Line impedance synthesis circuit (ACLISC) for a telecommunication line circuit which is coupled to line terminals (A,B) of a two-wire bi-directional telecommunication line and including a pair of operational line amplifiers (LOA0, LOA1) coupled to first terminals (STA,SRB) of a pair of line feed resistances (R0, R1) whose second terminals (STB,SRA) are coupled to said line terminals (A,B) of said two-wire bi-directional telecommunication line, said first and second pairs of line feed resistance terminals being coupled to a sensing circuit (SENC) which is able to sense the DC/AC current in said feed resistances , said sensing circuit (SENC) including a Herther bridge, and having output terminals (C,D) coupled to respective input terminals of an operational sense amplifier (OA2), an output terminal of said sense amplifier being coupled to an input terminal (IN) of a linear time invariant electrical system (LS), an output terminal (OUT) of which is coupled to an input terminal of said operational line amplifiers (LOA0, LOA1), said linear time invariant electrical system being adapted to convert an electrical input signal (SIN) applied to said input terminal (IN) to an electrical output signal (SOUT) supplied by said output terminal (OUT), according to a transfer function having one variable pole, one variable zero and variable gain, characterized in that said linear time invariant electrical system (LS) includes a first subsystem (SUB1) adapted to receive said input signal (SIN) and to generate a first subsystem output signal (SOUTSUB1) as said input signal (SIN) multiplied with a first variable coefficient, a second subsystem (SUB2) adapted to perform a variable low-pass filtering of said input signal, thereby generating a second subsystem output signal (SOUTSUB2), a third subsystem (SUB3) adapted to multiply said second subsystem output signal (SOUTSUB2) with a second variable coefficient, thereby generating a third subsystem output signal (SOUTSUB3) and a summation circuit (SUM) to add said third subsystem output signal (SOUTSUB3) to said first subsystem output signal (SOUTSUB1) thereby generating said output signal (SOUT).

6. Line impedance synthesis circuit according to claim 5 characterized in that said first subsystem (SUB1) is realized by a first variable gain amplifier arrangement with a first variable gain value equal to said first variable coefficient.

7. Line impedance synthesis circuit according to claim 5 characterized in that said second subsystem (SUB2) has an input terminal (INSUB2) for receipt of said input signal (SIN) and an output terminal (OUTSUB2) for supplying said second subsystem output signal (SOUTSUB2), in that said second subsystem further includes a unity gain non-inverting amplifier circuit (AMP1) having an input terminal (INAMP1) and an output terminal (OUTAMP1), in that said second subsystem further includes a second variable gain amplifier arrangement (VAR2) with a second variable gain value smaller than one, said second variable gain amplifier arrangement (VAR2) having an input terminal (INVAR2) and an output terminal (OUTVAR2), in that said second subsystem (SUB2) further includes a resistor (REXT) and a capacitor (CEXT), said input terminal (INSUB2) of said second subsystem being coupled to a first terminal (R1) of said resistor (REXT), a second terminal (R2) of said resistor (REXT) being coupled to said input terminal (INAMP1) of said unity gain non-inverting amplifier circuit (AMP1) and being coupled to a first terminal (C1) of said capacitor (CEXT), said output terminal (OUTAMP1) of said unity gain non-inverting amplifier circuit (AMP1) being coupled to said output terminal (OUTSUB2) of said second subsystem and being coupled to said input terminal (INVAR2) of said second variable gain amplifier arrangement (VAR2), said output terminal (OUTVAR2) of said second variable gain amplifier arrangement (VAR2) being coupled to a second terminal (C2) of said capacitor (CEXT).

8. Line impedance synthesis circuit according to claim 5 characterized in that said third subsystem (SUB3) is realized by a third variable gain amplifier arrangement with a third variable gain value equal to said second variable coefficient, and in that said summation circuit (SUM) is realized by a summing amplifier arrangement.

9. Line impedance synthesis circuit according to claims 6,7 and 8 characterized in that apart from said resistor (REXT) and said capacitor (CEXT), said system forms part of an integrated circuit, in that said first variable gain value of said first variable gain amplifier arrangement is realized by a first variable ratio of a first set of variable resistors being included in said first variable gain amplifier arrangement , in that said second variable gain value of said second variable gain amplifier arrangement is realized by a second variable ratio of a second set of variable resistors being included in said second variable gain amplifier arrangement, in that said third variable gain value of said third variable gain amplifier arrangement is realized by a third variable ratio of a third set of variable resistors being included in said third variable gain amplifier arrangement.

10. Line impedance synthesis circuit according to claim 9 characterized in that said first variable gain amplifier arrangement further includes a first programmable non-volatile memory circuit adapted to store a first programmable gain value equal to said first variable gain value, in that said first variable gain amplifier arrangement further includes a first control circuit adapted to determine and to generate from said first programmable gain value said first variable ratio of said first set of variable resistors, in that said second variable gain amplifier arrangement further includes a second programmable non-volatile memory circuit adapted to store a second programmable gain value equal to said second variable gain value, in that said second variable gain amplifier arrangement further includes a second control circuit adapted to determine and to generate from said second programmable gain value said second variable ratio of said second set of variable resistors, and in that said third variable gain amplifier arrangement includes a third programmable non-volatile memory circuit adapted to store a third programmable gain value equal to said third variable gain value, in that said third subsystem further includes a third control circuit adapted to determine and to generate from this third programmable gain value said third variable ratio of said third set of variable resistors.

LS

SUB1    SOUTSUB1

SIN

IN    INSUB2

SUM    SOUT

OUT

OUTSUB2

SUB2    SUB3    SOUTSUB3

SOUTSUB2

Fig.1

INAMP1    OUTAMP1

INSUB2    REXT    AMP1    OUTSUB2

R1    R2

C1

CEXT

SUB2    C2

OUTVAR2    INVAR2

VAR2    Fig. 2

ACLISC

Fig.3

**European Patent Office**

## EUROPEAN SEARCH REPORT

Application Number

EP 96 20 0160

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | WO-A-93 21723 (NORTHERN TELECOM LTD) 28 October 1993 <br> * page 4, line 20 - page 7, line 13; figures 1,2 * <br> --- | 1,2,5,6 | H03H11/04 |
| A | US-A-4 484 032 (ROSENBAUM STANLEY D) 20 November 1984 <br> * column 2, line 40 - line 59; figure 1 * <br> --- | 5 | |
| A | EP-A-0 314 235 (ELECTRONIQUE & PHYSIQUE ;PHILIPS NV (NL)) 3 May 1989 <br> * page 7, line 6 - line 13; figure 1 * <br> ----- | 1 | |
| | | | **TECHNICAL FIELDS SEARCHED** (Int.Cl.6) |
| | | | H03H |

The present search report has been drawn up for all claims

| Place of search | Date of completion of the search | Examiner |
|---|---|---|
| THE HAGUE | 26 June 1996 | D/L PINTA BALLE.., L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document